# FASCICULE DE BREVET EUROPEEN

(11) **EP 1 551 851 B1**
(45) Date de publication et mention de la délivrance du brevet: **02.08.2006**
(21) Numéro de dépôt: 03798226.1
(22) Date de dépôt: 25.09.2003
(51) Int. Cl.: C07F 1/00, C07F 1/08, C07F 1/10, C23C 16/18

(54) **COMPLEXES METALLIQUES EXEMPTS DE FLUOR POUR LE DEPOT CHIMIQUE DE METAUX EN PHASE GAZEUSE**
FLUORFREIE METALLKOMPLEXE ZUM CHEMISCHE GASPHASENABSCHEIDUNG
FLUORINE-FREE METALLIC COMPLEXES FOR GAS-PHASE CHEMICAL METAL DEPOSITION

(30) Priorité: 30.09.2002 FR 0212059
(43) Date de publication de la demande: 13.07.2005
(73) Titulaire: CENTRE NATIONAL DE LA RECHERCHE SCIENTIFIQUE, 75794 Paris Cedex 16 (FR)
(72) Inventeur: DOPPELT, Pascal, F-93130 Noisy-Le-Sec (FR)
(74) Mandataire: Corizzi, Valérie
(86) Numéro de dépôt international: PCT/FR2003/002820
(87) Numéro de publication internationale: WO 2004/029061

(56) Documents cités:
- US-A- 5 085 731

## Description

L'Invention a pour objet de nouveaux complexes de cuivre (I) ou d'argent (I) et leur utilisation pour le dépôt chimique en phase gazeuse de cuivre ou d'argent métalliques pratiquement exempts d'impuretés.

L'industrie électronique produit des circuits intégrés pour lesquels l'exigence en termes de miniaturisation, de rapidité et de capacité de stockage de l'information est toujours plus grande. La fabrication de films métalliques pour réaliser les interconnexions métalliques dans les circuits intégrés par un procédé de dépôt métallique en phase vapeur est bien connue de l'homme du métier. Un tel procédé est généralement désigné CVD pour « Chemical Vapour Deposition ». Cette méthode utilise des précurseurs de ces métaux sous forme oxydée (+1) comme produits de départ.

On connaît dans l'art antérieur de nombreux précurseurs du cuivre pour l'élaboration de films constitués de cuivre pur. Les précurseurs les plus prometteurs sont des complexes de coordination du cuivre à l'état oxydé (+1) stabilisé par un ligand dans lesquels le cuivre est coordonné à une β-dicétonate, répondant à la formule générale (I) suivante : 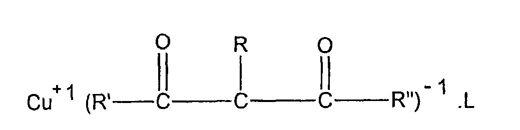 dans laquelle, R, R' et R", identiques ou différents, sont choisis parmi un atome d'hydrogène, un atome d'halogène comme le fluor, un groupement alkyle en C₁-C₈ éventuellement substitué par un ou plusieurs atomes de fluor.

Des complexes préférés sont ceux dans lesquels R est un atome d'hydrogène et R' et R" sont des alkyles perfluorés et avantageusement des groupes - CF₃ répondant à la formule développée suivante :

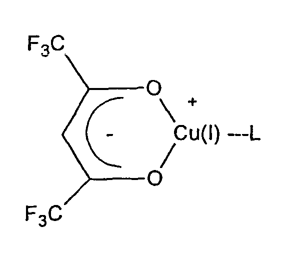

De tels complexes et leur utilisation pour la CVD sont décrits par exemple dans les Brevets US No 5 085 731, 5 096 737, 5 098 516, 5 144 049, 5 187 300 et dans la Demande Internationale No 98/40387.

Les travaux réalisés sur ces précurseurs montrent que leur structure moléculaire est décisive pour l'obtention reproductible de films de bonne qualité (P. Doppelt et T. H. Baum, MRS Bull. XIX(8) 41, 1994, T. Y. Chen, J. Vaissermann, E. Ruiz, J. P. Senateur, P. Doppelt, *Chem. Mat*. **13**, 3993 (2001)).

Comme cela a été décrit dans les Brevets cités ci-dessus, la formation du cuivre métallique est le résultat d'une dismutation de deux molécules de cuivre (1) sur une surface chauffée à une température voisine de 200°C suivant le schéma réactionnel suivant :

2Cu(hfac)L → Cu(II)(hfac)₂ + Cu(O) + 2L

dans lequel hfac représente l'anion hexafluoro acétylacétonate et L représente la base de Lewis ou Ligand. Le mécanisme est le même pour les autres complexes de cuivre (I) et pour les complexes de l'argent (I).

La nature de la base de Lewis L, aussi désignée ci-après le ligand, influence très peu la nature des films de cuivre obtenus par CVD. Les films de cuivre sont généralement très purs, et notamment exempts d'atomes de carbone, d'oxygène et de fluor (moins de 1%). Une résistivité de l'ordre de 1.8 µΩ.cm est couramment trouvée dans les films de cuivre obtenus par CVD ; cette valeur est très proche de celle trouvée dans le cuivre massif (1.67 µΩ.cm).

En revanche la nature du Ligand L détermine la volatilité du complexe et en conséquence la vitesse du dépôt de cuivre.

Dans les documents de l'art antérieur, notamment dans US-5,098,516 et US-5,144,049, la préférence est généralement donnée à des complexes de cuivre (I) et d'anions porteurs d'atomes de fluor, en particulier en raison de leur volatilité, qui permet d'effectuer le dépôt métallique à des températures plus basses que lorsque l'anion n'est pas une molécule fluorée, et également en raison de la plus grande stabilité de ces complexes.

La technologie prévue pour la métallisation par le cuivre de composants électroniques implique que le cuivre soit déposé sur un film barrière qui empêche le cuivre de diffuser dans le diélectrique et permet l'intégrité du contact électrique.

Cette barrière est choisie parmi des matériaux tels que TiN, TaN ou WN (respectivement nitrure de titane, de tantale ou de tungstène) ou Ta métal. D'autres matériaux peuvent éventuellement être utilisés.

Or, dans certains cas, en particulier lorsque le film de cuivre est déposé su TiN, Ta ou TaN, comme le demande la technologie, même si le film de cuivre ne contient qu'une quantité très faible de fluor, ce fluor diffuse et se trouve concentré à l'interface entre le cuivre et la barrière.

Ce phénomène a été décrit notamment par K. Weiss, S. Riedel, S. E. Schultz, T. Gessner, *AMC 1998, MRS Proceedings page 171.*

Il a pour conséquence :
1) une rupture dans la conductivité électrique entre le transistor de base et le film de cuivre qui augmente globalement la résistivité du contact, en raison du caractère isolant du film riche en fluor ;
2) une adhésion insuffisante du film de cuivre sur le film barrière.

Les composés décrits dans le document WO 98/40387 apportaient une première réponse à ce problème.

Toutefois, il subsiste le besoin d'un complexe de cuivre (I) ou d'argent (I) pour la fabrication reproductible de circuits électroniques à base de films minces de cuivre ou d'argent permettant le remplissage de lignes et interconnexions verticales sans défaut et avec une faible résistivité et une bonne stabilité thermique à long terme.

En particulier, il subsiste le besoin d'un précurseur qui soit complètement exempt d'atomes de fluor, tout en étant volatil et suffisamment stable pour être industriellement exploité.

Enfin, ce précurseur doit se décomposer thermiquement suivant la réaction de dismutation donnée précédemment pour assurer une grande pureté au film métallique déposé.

La Demanderesse a mis au point de nouveaux composés, qui sont des complexes de cuivre (I) ou d'argent (I), dépourvus de fluor, précurseurs du cuivre ou de l'argent dans le procédé de dépôt métallique en phase gazeuse, ces composés remédiant aux inconvénients de l'art antérieur.

Les composés selon l'Invention sont caractérisés en ce qu'ils répondent à la formule (I) ci-dessous : 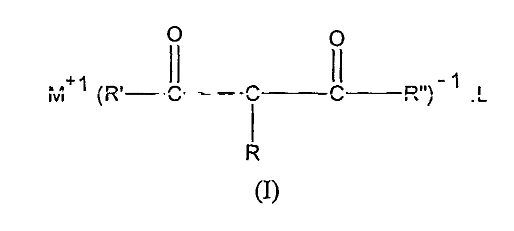 dans laquelle
- M représente un atome de cuivre ou un atome d'argent ;
- R' et R", identiques ou différents représentent un groupement choisi parmi : un alkyle en C₁-C₈; un groupement -OR''', dans lequel R''' représente un alkyle en C₁-C₈ ;
- R représente un groupement choisi parmi : un groupement - OR'''', dans lequel R'''' représente un alkyle en C₁-C₈ ; un groupement nitro : NO₂ ; une fonction aldéhyde : -CHO ; une fonction ester -COOR''''', dans laquelle R''''' représente un groupement alkyle en C₁-C₈ ;
- L représente le ligand de stabilisation de ce complexe.

L peut être choisi parmi les ligands utilisés dans l'art antérieur comme stabilisateurs des complexes de cuivre (I), notamment les ligands décrits dans les documents déjà cités ci-dessus.

Parmi les ligands utilisables dans la présente Invention, on peut citer :
a- le monoxyde de carbone,
b- les ligands hydrocarbonés insaturés comportant au moins une insaturation non aromatique, et notamment parmi ces derniers : l'éthylène, l'acétylène, le 1-octène, l'isobutylène, le 1,5-cyclooctadiène, le stilbène, le diphénylacétylène, le styrène, le cyclooctène, le 1,5,9-cyclododécatriène, le 1,3-hexadiène, l'isopropylacétylène, le 1-décène, le 2,5-bicycloheptadiène, le 1-octadécène, le cyclopentène, l'octaline, le méthylène cyclohexane, le diphénylfulvène, le 1-octadécyne, le benzylcinnamate, le benzal acétophénone, l'acrylonitrile, l'anhydride maléique, l'acide oléique, l'acide linoléique, l'acide acrylique, le méthacrylate de méthyle, le maléate de diéthyle, le méthyl-1,5-cyclooctadiène, le diméthyl-1,5-cyclooctadiène, le méthylcyclooctène, le cycloocta tétraène, le norborène, le norboradiène, le tricyclo [5.2.1.0]-déca-2,6-diène, le 1,4-cyclohexadiène, le [4,3,0]bicyclo-nona-3,7-diène ;
c- les isonitriles tels que notamment le méhyl isocyanide, le butyl isocyanide, le cyclohexyl isocyanide, le phényl éthyl isocyanide, le phényl isocyanide ;
d- les phosphines, tels que par exemple la tri-méthyl phosphine, la tri-éthyl phosphine,
e- les composés répondant à la formule (II) ci-dessous :

   (R¹)(R²)C = C(R³)Si(R⁴)(R⁵)(R⁶)

   dans laquelle
   - R¹ représente l'atome d'hydrogène ou un groupement alkyle en C₁-C₈, ou un groupement SiR⁴R⁵R⁶.
   - R² et R³, identiques ou différents, représentent l'atome d'hydrogène ou un groupement alkyle en C₁-C₈,
   - R⁴, R⁵ et R⁶, identiques ou différents, représentent un groupement phényle ou alkyle en C₁-C₈ ;
f- les composés répondant à la formule (III) ci-dessous :

   R⁷―C≡C―Si(R⁸)(R ⁹)(R¹⁰) (III)

   dans laquelle
   - R⁷ représente un groupement alkyle en C₁-C₈, phényle, ou Si(R⁸)(R⁹)(R¹⁰) ;
   - R⁸, R⁹, R¹⁰, identiques ou différents, représentent un groupement alkyle en C₁-C₈ ou phényle ;
g- les composés répondant à l'une des formules (IV), (V) et (VI) ci-dessous : 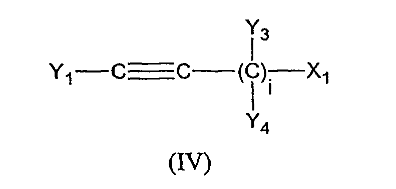 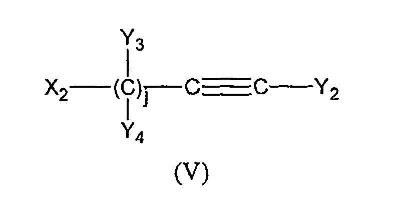 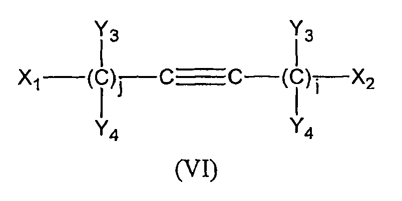
dans lesquelles Y₁, Y₂, Y₃ et Y₄, identiques ou différents, sont choisis parmi un atome d'hydrogène, un alkyle en C₁-C₈, un groupe -Si(R₅)₃ où R₅ est un alkyle en C₁-C₈, i et j représentent un entier choisi parmi 0, 1, 2, 3, et X₁ et X₂, identiques ou différents, représentent un groupement attracteur d'électrons tels que notamment un alcényle en C₁-C₈ ; des exemples de produits répondant aux formules (IV), (V) et (VI) sont illustrés dans la Demande Internationale WO 98/40387.

Au sens de la présente Invention, le terme alkyle désigne les radicaux hydrocarbonés linéaires, ramifiés ou cycliques. Il est entendu notamment que deux radicaux alkyle d'une même molécule peuvent être joints pour former une molécule cyclique.

Les molécules préférées de la présente Invention sont celles répondant à la formule (I) pour lesquelles une ou plusieurs des conditions ci-dessous sont remplies :
- M représente l'atome de cuivre
- R' ou R" représentent un groupement choisi parmi CH₃ et C₂H₅,
- R représente un groupement choisi parmi NO₂ et OCH₃,
- L représente un ligand choisi parmi le 1,5--cyclooctadiène et le bis(triméthylsilyl)acétylène.

Les composés de la présente Invention peuvent être préparés par un procédé déjà décrit dans l'art antérieur : P. Doppelt, T. H. Baum, L. Richard, *Inorg. Chem*. **35,** 1286, 1996.

L'Invention a également pour objet un procédé pour le dépôt chimique en phase gazeuse d'un métal choisi parmi le cuivre et l'argent sur un support. Le support peut être constitué par un matériau choisi notamment parmi Si, AsGa, InP, SiC, SiGe. La couche de cuivre peut être déposée sur ledit support comme première couche ou comme n^{ième} couche de métallisation pour les dispositifs électroniques nécessitant plusieurs niveaux de métallisation, n étant un entier supérieur ou égal à 2. Le support peut être constitué par l'un des matériaux précités pris tel quel, ou bien par l'un de ces matériaux portant une ou plusieurs couches intermédiaires. A titre d'exemple de couches intermédiaires, on peut citer les couches de diffusion constituées par au moins un matériau choisi par exemple parmi TiN, TiSiN, Ta, TaN, TaSiN, WN, WSiN. Le procédé selon l'Invention consiste à appliquer un procédé de dépôt chimique en phase gazeuse, ou CVD, déjà connu de l'art antérieur aux composés précurseurs de cuivre et d'argent décrits ci-dessus.

Ce procédé permet notamment de faire un dépôt sélectif du métal choisi sur la surface électriquement conductrice du support tout en évitant de le déposer sur les portions isolantes de ce même support, telles que par exemple les portions en dioxyde de silicone des supports de circuits intégrés.

Avantageusement, ce procédé est mis en oeuvre à une température allant de 120 à 300°C.

Selon le cas, le composé selon l'Invention est utilisé pur lorsque ce composé est un liquide à température ambiante, ou en solution si ce composé est solide à température ambiante.

Les composés solides sont avantageusement dissous dans un solvant hydrocarboné, notamment dans un solvant hydrocarboné cyclique tel que par exemple le cyclohexane ou le tétrahydrofuranne ou des solvants aromatiques comme le toluène, le xylène ou le mésitylène. Les composés selon l'Invention peuvent être utilisés dans un équipement standard pour CVD tel qu'utilisé couramment dans l'industrie électronique. Ils présentent l'avantage de ne pas relarguer de composés nocifs susceptibles d'endommager un substrat pour circuit intégré ou de diminuer sa sélectivité.

Lors de la mise en oeuvre du procédé de dépôt de couches de cuivre ou d'argent sur un support, la composition contenant le précurseur de métal est envoyée dans un dispositif de vaporisation par l'intermédiaire duquel elle est introduite dans le réacteur qui contient le support sur lequel la couche de cuivre ou d'argent doit être déposée. Avant son arrivée dans le dispositif de vaporisation, la composition est généralement maintenue dans un réservoir à température ambiante. La vaporisation de la composition de précurseur peut être effectuée à l'aide de divers dispositifs connus de l'homme de métier. A titre d'exemple préféré, on peut citer le dispositif décrit dans le document T. Y. Chen, J. Vaissermann, E. Ruiz, J. P. Sénateur, P. Doppelt, *Chem. Mat*. 2001, **13,** 3993. Ledit dispositif commercialisé par la société Jipelec sous le nom de « TriJet Liquid Precursor Delivery and Evaporation System» comprend trois parties principales : le réservoir, un injecteur et un évaporateur. La solution de complexe de cuivre (I) qui est située dans le réservoir maintenue à une pression de 1 bar, est propulsée grâce à l'injecteur par différence de pression dans l'évaporateur qui est maintenu sous vide. Le débit d'injection est contrôlé par une micro-électrovanne commandée par un ordinateur. L'évaporateur ainsi que le reste du montage qui consiste principalement en une chambre de réaction pour un seul support, sont maintenus à la même température.

L'épaisseur de cuivre qui se dépose sur le support dépend de la concentration de la composition de précurseur, du débit de cette composition lors du passage dans le dispositif de vaporisation, de la durée de la vaporisation, des températures respectives dans le réacteur et sur le support. De manière générale, on utilise des compositions moins concentrées et/ou des débits plus faibles pour l'obtention de couches fines, et des compositions plus concentrées et/ou des débits plus élevés pour l'obtention de couches épaisses. Par couche fine, on entend généralement une couche ayant une épaisseur inférieure à ou égale à 50 nm, dite couche de nucléation. Par couche épaisse, on entend généralement une couche ayant une épaisseur entre 50 nm et 1 µm. Le procédé selon l'Invention permet de réaliser à partir de précurseurs des métaux sous forme oxydée (+1) les interconnexions et métallisation de circuits intégrés d'une épaisseur allant de 0,2 à 500 nm, préférentiellement de 0,2 à 50 nm.

L'utilisation des compositions selon l'invention pour l'élaboration de couches de cuivre par CVD permet d'obtenir des couches de cuivre de bonne qualité ayant une bonne adhérence au support sur lequel elles sont déposées.

### PARTIE EXPERIMENTALE :

### Abréviations utilisées :

acac : anion de l'acétylacétone.
COD : 1,5-cyclooctadiène.
BTMSA : bis-(triméthylsilyl)-acétylène.
EDTA : éthylènediaminetétracétique disodique.
GCMS : Gas Chromatography Mass Spectroscopy
3-NO₂-acac : anion de la 3-nitro-acétylacétone
3-MeO-acac : anion de la 3-MeO-acétylacétone

### I- Synthèses des β-dicétones non fluorées

### I-1. Synthèse de la 3-NO₂-acac :

La synthèse de NO₂-acac se déroule en deux étapes comme décrit dans la littérature par Z. Yoshida, H. Ogoshi and T. Tokumitsu, *Tetrahedron*, 1970, **26**, 5691. La première étape consiste à former le complexe de cuivre (II) : bis-(3-nitro-2,4-pentanediono)-cuivre (II) (Cu(NO₂-acac)₂), la deuxième à isoler la β-dicétone par décomplexation en utilisant de l'EDTA.

### a- Synthèse du Cu(NO₂-acac)₂ :

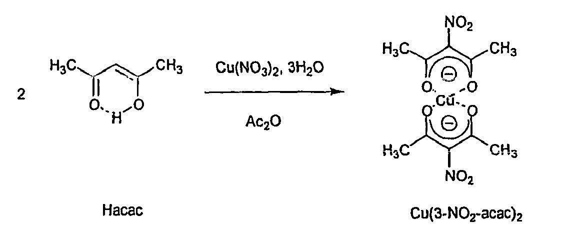

Dans un ballon, on introduit 50 ml d'anhydride acétique et 10ml (0.09 mol) d'acétylacétone. Sous agitation et à 0°C (bain eau/glace), on ajoute alors 7,89g (33 mmol) de nitrate de sodium trihydraté (en plusieurs fractions car la réaction est exothermique). Le milieu réactionnel est laissé sous agitation pendant deux heures à 0°C puis dix-huit heures à température ambiante.

La solution de couleur verte est ensuite traitée avec une solution acétate de sodium/eau glacée (environ 100 ml) qui donne un précipité vert en suspension qui est filtré sur Büchner puis séché sous P₂O₅. Le rendement est de 42%.

Point de fusion : 240°C (déc.). IR (cm⁻¹) : 1586 (γ C=O), 1525 (γₐₛ NO₂), 1336 (γₛNO₂). Sublimation à T = 100°C sous P = 4.10⁻² mbar.

### b- Synthèse de la 3-NO₂-acac :

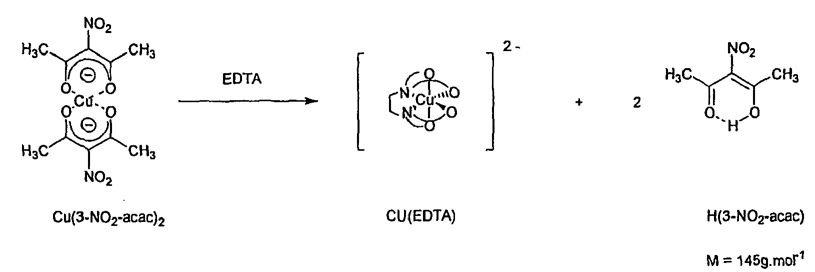

Dans un ballon de 500 mL, on introduit 9,3g (22.8 mmol) de Cu(NO₂₋acac)₂ en suspension dans 120 ml de dichlorométhane. On ajoute 120 ml d'eau et on obtient deux phases : la phase organique colorée (où se solubilise le complexe de cuivre (II)) et la phase aqueuse (où se forme le complexe cuivre/EDTA). On additionne de l'EDTA jusqu'à l'obtention d'une phase organique décolorée. La phase organique est séparée de la phase aqueuse par décantation et séchée sur MgSO4. La dicétone nitrée est obtenue par évaporation du solvant et purifiée par distillation sous pression réduite (P = 10-1 mbar, T = 45°C). Le rendement est de 77%.

GCMS : 1 pic à m/z = 145. RMN (CDCl₃ , T=297 K) : ¹H δ(ppm) : 15.11 (s, 1H, -C-O-H...O=C-), 2.50 (s, 6H, 2 -CH₃). ¹³C δ(ppm) : 192.4 (s, -C=O), 134.7 (s, =C-NO₂), 24.8 (s, -CH₃)

### I-2. Synthèse de la 4-NO₂-3,5-heptanedione :

### a- Synthèse de la 4-Cu(NO₂-3.5-heptanedione)₂ :

Le mode opératoire est identique à celui permettant la préparation de Cu(NO₂-acac)₂.

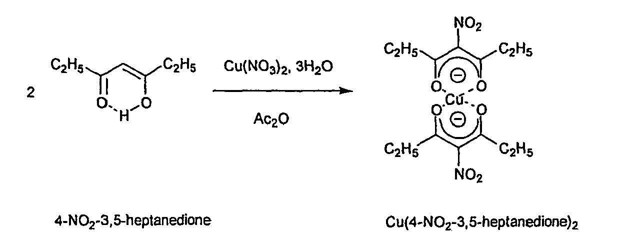

Le mélange réactionnel est constitué de :
- 10 g (78 mmol) de 3.5-heptanedione dans 50 ml d'anhydride acétique.
- 6.91g (29 mmol) de nitrate de sodium trihydraté.

Le produit obtenu est un solide vert foncé. Le rendement brut est de 60-65%. Le composé peut être recristallisé dans un mélange hexane/méthanol (30 ml/10ml).

Point de fusion : 252°C. IR (cm⁻¹): 1582 (γ C=O), 1523 (γₐₛ NO₂), 1343 (γₛNO₂). Sublimation à T = 120°C sous P = 5.10⁻² mbar.

### b- préparation de la 4-NO₂-3,5-heptanedione :

Le mode opératoire est identique à celui de la préparation de la 3-NO₂₋acac :

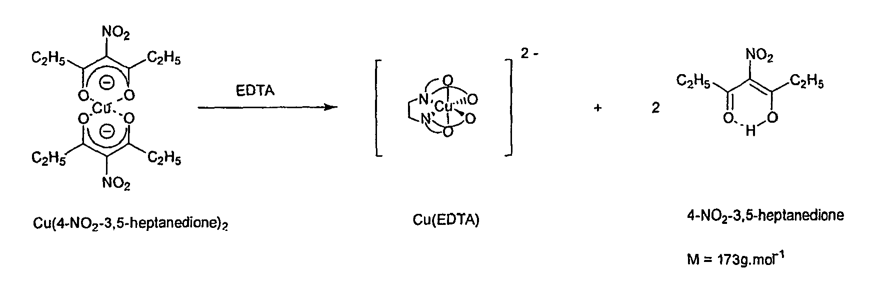

Le mélange réactionnel est constitué de :
- 7,72 g (17.7 mmol) de Cu (NO₂-3,5-heptanedione)₂
- 100 ml de dichlorométhane et 100 ml d'eau.
- EDTA.

La dicétone est purifiée par distillation sous pression réduite (P = 10⁻¹ mbar, T = 150°C). Le rendement est de 58%.

GCMS : 1 pic unique pour m/z = 173 . RMN (CDCl₃ , T=297 K), ¹H δ(ppm) : 15.17 (s, 1H, -C-O-H...O=C-), 2.18 (q, 4H, J³_{H-H} = 7.35 Hz, 2 -CH₂), 1.23 (t, 6H, J³_{H-H} = 7.35 Hz, 2 -CH₃), ¹³C δ(ppm) : 194.9 (s, -C=O), 135.3 (s, =C-NO₂), 29.9 (s, -CH₂), 8.9 (s, -CH₃)

### I-3. Synthèse de la 3-MeO-acac :

Nous avons suivi le mode opératoire de préparation de ce ligand qui a été décrit par R. M. Moriarty, R. K. Vaid, V. T. Ravikumar, B. K. Vaid and T. E. Hopkins, *Tetrahedron,* 1988, **44**, 1603.

### II- Synthèse des complexes de cuivre (I)

Pour les complexes de cuivre (I) contenant le groupement NO₂- ou le groupement -OMe, nous avons choisi la synthèse utilisant la réaction de la β-dicétone sur l'oxyde de cuivre (I) en présence de base de Lewis comme décrit précédemment par P. Doppelt, T. H. Baum, *MRS Bulletin*, 1994, XIX(8), 41, car les β -dicétones correspondantes ont un caractère acide suffisant pour que la réaction se produise avec un bon rendement. Dans tous les cas il a fallu travailler sous atmosphère contrôlée (sous azote).

### II-1. Préparation du (3-NO₂-acac)Cu(BTMSA) :

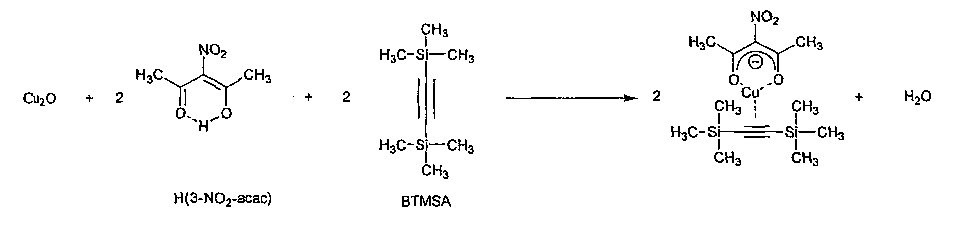

Dans un ballon de 100 mL, 1,03g (7.22 mmol) de Cu₂O et 1,6 ml (7 mmol) de BTMSA sont agités sous flux d'azote dans 20 ml de dichlorométhane. On ajoute goutte à goutte à la seringue 1g soit 6.9mmol de 3-NO₂-acac. Très rapidement, la solution prend une couleur jaune-vert . On laisse l'agitation sous N₂ pendant deux heures.

Après filtration sous azote, la solution est passée dans une colonne de silice (diamètre intérieur 3 cm, hauteur 4 cm). Après évaporation sous vide, on obtient un solide jaune. Ce complexe est assez stable à l'air mais doit être stocké sous azote. Le rendement est de 90%.

Point de fusion = 100°C. IR (cm⁻¹) : 1582 (γ C=O), 1511 (γₐₛ NO₂), 1349 (γₛ NO₂). RMN (CDCl₃ , T=297 K) ¹H δ(ppm) : 2.26 (s, 6H, 2 -CH₃ de NO₂-acac), 0.31 (s, 18 H, 6 -CH₃ de BTMSA) ¹³C δ(ppm) : 189.0 (s, -C=O), 139.0 (s, =C-NO₂), 27.6 (s, -CH₃ sur NO₂-acac), 0.0 (s, -CH₃ de BTMSA). Sublimation à T = 50°C - 60°C sous P = 5.10⁻² mbar.

### II-2. Préparation du (3-NO₂-acac)Cu(COD) :

On utilise le même mode opératoire que pour la préparation du (3-NO₂₋acac)Cu(BTMSA)

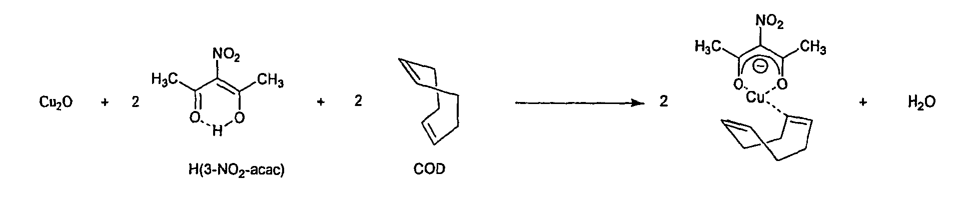

Le mélange réactionnel est constitué de :
- 0,83g (5.79 mmol) de Cu₂O.
- 0,7 ml (5.64 mmol) de COD.
- 0,8g (5.52 mmol) de 3-NO₂-acac.
- 30 ml de CH₂Cl₂.

Le produit obtenu est un solide jaune. Le rendement est de 60%.

Point de fusion : 145°C (déc). RMN (CDCl₃ , T=297 K) ¹H δ(ppm) : 5.46 (s, 4H, 2 -HC=CH- du COD), 2.43 (s, 8H, 4 -CH₂- du COD), 2.22 (s, 6H, 2 -CH₃ de NO₂₋acac), ¹³C δ(ppm) : 188.4 (s, -C=O), 138.5 (s, =C-NO₂), 114.7 (s, =CH-), 28.0 (s, -CH₂-), 24.9 (s, -CH₃). Sublimation à T = 60°C pour P = 2.10⁻¹ mbar.

### II-3. Préparation du (4-NO₂-3,5-heptanedionato)Cu(BTMSA) :

On utilise un mode opératoire identique à celui employé pour la préparation de (NO2-acac)Cu(BTMSA).:

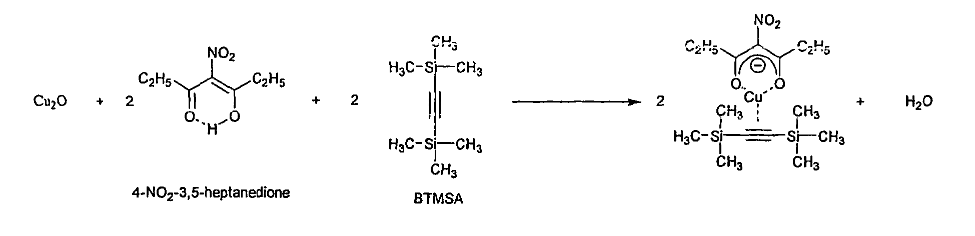

Le mélange réactionnel est constitué de :
- 0,598g (4.18 mmol) de Cu₂O,
- 0,95 ml (4.08 mmol) de BTMSA,
- 0,69g (3.99 mmol) de NO₂-3,5-heptanedione,
- 20 ml de CH₂Cl₂.

Un solide jaune est obtenu avec un rendement de 81%. Sa stabilité est comparable à celle de (3-NO₂-acac)Cu(BTMSA).

Point de fusion : 90°C. IR (cm⁻¹) : 1587 (γ C=O), 1513 (γₐₛ NO₂), 1342 (γₛ NO₂). RMN (CDCl₃ , T=297 K) ¹H δ(ppm) : 2.53 (q, 4H, J³_{H-H} =7.35 Hz, 2 -CH₂- de dicétone), 1.12 (t, 6H, J³_{H-H} =7.35 Hz, 2 -CH₃ de dicétone), 0.32 (s, 18H, 6 -CH₃ de BTMSA), ¹³C δ(ppm) : 191.2 (s, -C=O), 138.7 (s, =C-NO₂), 31.5 (s, -CH₂), 10.0 (s, -CH₃ sur dicétone), 0.0 (s, -CH₃ sur BTMSA). Sublimation à T= 60°C sous P = 5.10⁻² mbar.

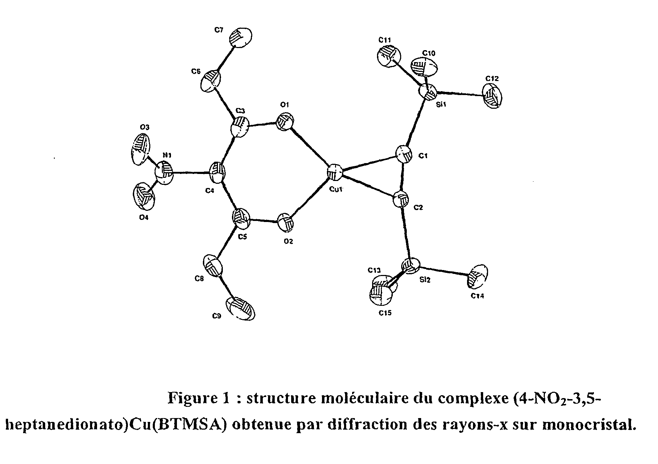

Nous avons réussi à obtenir pour ce complexe des monocristaux qui ont été utilisés pour déterminer la structure du complexe par diffraction des rayons-X. Cette structure est représentée sur la figure 1. La structure est très proche de celle des complexes correspondants contenant du fluor et qui ont été décrits par P. Doppelt, T. H. Baum, *J. Organomet. Chem.* 1996, **517**, 53. Aucune interaction intermoléculaire susceptible de gêner la vaporisation du complexe n'a été mise en évidence.

### II-4. Préparation du (3-MeO-acac)Cu(BTMSA) :

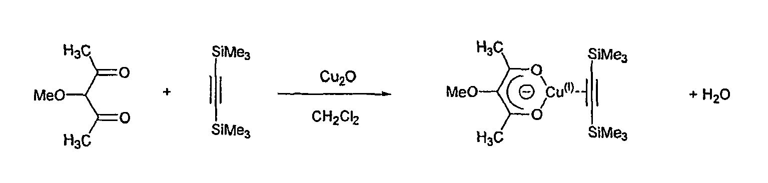

A une suspension de Cu₂O (1,03g, 7.22 mmol) dans 40 ml de dichlorométhane, on ajoute sous azote 1,6 ml (7 mmol) de BTMSA. Après 30 minutes, on ajoute goutte à goutte 915 mg (7 mmol) de 3-méthoxy-2,4-pentanedione. La solution devient rapidement jaune orange et est laissée sous agitation à température ambiante pendant 3 heures et filtrée à l'aide une canule en PTFE. Après évaporation du solvant, un résidu orange est obtenu. Ce solide est redissout dans un minimum de dichlorométhane et passé sur une colonne de silice (diamètre intérieur 3 cm, hauteur 4 cm). On obtient ainsi un solide blanc. ¹H NMR (CDCl₃, 300 MHz): 3.45 (s, 3H, O-CH₃), 2.05 (s, 6H, 2x C-CH3), 0.2 (s, 18 H, 6x Si-CH₃); IR (cm⁻¹): 1583 (C=O), 1921 (C≡C).

### III. Dépôts CVD utilisant des solutions de (4-NO₂-3,5-heptanedionato)Cu(BTMSA)

Les complexes de cuivre décrits ici étant des solides, ils peuvent être utilisés purs dans un bulleur ou préférentiellement dissous dans un solvant neutre comme le cyclohexane, le tétrahydrofuranne ou des solvants aromatiques comme le toluène, le xylène ou le mésitylène.

Le (4-NO₂-3,5-heptanedionato)Cu(BTMSA) a été testé :

La réaction de décomposition du complexe est la réaction de dismutation suivante :

**2 (β-dicétonate)CuL (I) → Cu (0) + Cu(β-dicetonate)**_{**2**} **(II) + 2L**

La réaction ne nécessite pas l'action d'un gaz réactif, les espèces formées Cu(β-dicétonate)₂ (II) et L sont volatiles et évacuées du système.

Nous avons utilisé une concentration assez élévée de 1 g de complexe dans 10 g de cyclohexane. Des concentrations plus élevées peuvent être utilisées, le complexe étant très soluble dans la plupart des solvants organiques. Des concentrations plus faibles peuvent être utilisées si l'application est plutôt un film de cuivre comme couche de nucléation pour dépôt électrochimique comme indiqué plus haut.

De plus, pour augmenter la stabilité de la solution, 100 mg de BTMSA ont été ajoutés. Cette dernière étape n'est pas obligatoire et peut être annulée si le produit est suffisament stable.

A l'aide de cette composition de (4-NO₂-3,5-heptanedionato)Cu(BTMSA), on a déposé un film de cuivre sur un support maintenu à 250°C et placé dans un réacteur à 100°C sous une pression de 5 Torr. La composition de (4-NO₂-3,5-heptanedionato)Cu(BTMSA) est envoyée dans un dispositif de vaporisation en même temps que de l'azote gazeux. Le débit de l'azote était de 100 sccm (standard cubic centimeter minute).

Dans un premier essai, le support était une plaquette de silicium qui a un diamètre de 4 pouces et qui est recouverte d'un film de TiN ayant une épaisseur de 200 nm, et le débit de composition de précurseur était de 0,4 ml/min. Dans un second essai, le support était une plaquette de silicium qui a un diamètre de 8 pouces et qui est recouverte d'un film de TiN ayant une épaisseur de 200 nm, et le débit de composition de précurseur était de 2,4 ml/min.

On a obtenu dans chaque cas un film de cuivre adhérent de bonne qualité avec une vitesse de croissance de 1 à 5 nm/min.

## Revendications

1. Composés **caractérisés en ce qu'**ils répondent à la formule (I) ci-dessous : 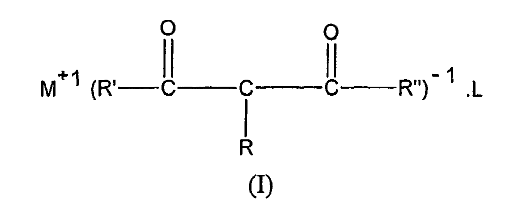 dans laquelle
- M représente un atome de cuivre ou un atome d'argent ;
- R' et R", identiques ou différents représentent un groupement choisi parmi : un alkyle en C₁-C₈ ; un groupement -OR"', dans lequel R''' représente un alkyle en C₁-C₈ ;
- R représente un groupement choisi parmi : un groupement - OR'''', dans lequel R'''' représente un alkyle en C₁-C₈ ; un groupement nitro : NO₂ ; une fonction aldéhyde : -CHO ; une fonction ester -COOR''''', dans laquelle R''''' représente un groupement alkyle en C₁-C₈ ;
- L représente un ligand de stabilisation.

2. Composé selon la formule (I), **caractérisé en ce que** L est choisi parmi :
a- le monoxyde de carbone,
b- les ligands hydrocarbonés insaturés comportant au moins une insaturation non aromatique,
c- les isonitriles,
d- les phosphines,
e- les composés répondant à la formule (II) ci-dessous :
(R¹)(R²)C = C(R³)Si(R⁴)(R⁵)(R⁶)
dans laquelle
- R¹ représente l'atome d'hydrogène ou un groupement alkyle en C₁-C₈, ou un groupement SiR⁴R⁵R⁶.
- R² et R³, identiques ou différents, représentent l'atome d'hydrogène ou un groupement alkyle en C₁-C₈,
- R⁴, R⁵ et R⁶, identiques ou différents, représentent un groupement phényle ou alkyle en C₁-C₈ ;
f- les composés répondant à la formule (III) ci-dessous :
R⁷―C≡C―Si(R⁸)(R⁹)(R¹⁰) (III)
dans laquelle
- R⁷ représente un groupement alkyle en C₁-C₈, phényle, ou Si(R⁸)(R⁹)(R¹⁰) ;
- R⁸, R⁹, R¹⁰, identiques ou différents, représentent un groupement alkyle en C₁-C₈ ou phényle ;
g- les composés répondant à l'une des formules (IV), (V) et (VI) ci-dessous : 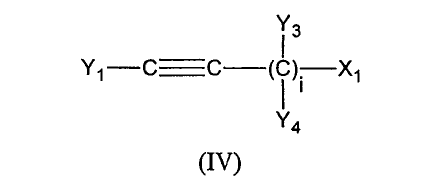 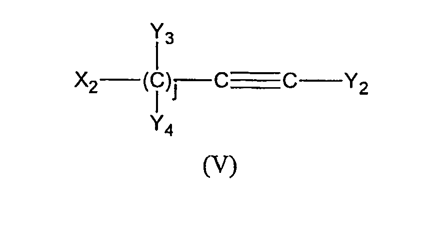 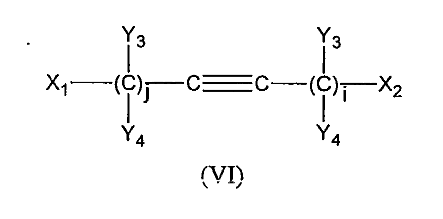
dans lesquelles Y₁, Y₂, Y₃ et Y₄, identiques ou différents, sont choisis parmi un atome d'hydrogène, un alkyle en C₁-C₈, un groupe -Si(R₅)₃ où R₅ est un alkyle en C₁-C₈, i et j représentent un entier choisi parmi 0, 1, 2, 3, et X₁ et X₂, identiques ou différents, représentent un groupement attracteur d'électrons tels que notamment un alcényle en C₁-C₈.

3. Composé selon la revendication 1 ou la revendication 2 **caractérisé en ce que** M représente l'atome de cuivre.

4. Composé selon l'une quelconque des revendications 1 à 3 **caractérisé en ce que** R' ou R" représentent un groupement choisi parmi CH₃ et C₂H₅.

5. Composé selon l'une quelconque des revendications 1 à 4 **caractérisé en ce que** R représente un groupement choisi parmi NO₂ et OCH₃.

6. Composé selon l'une quelconque des revendications 1 à 5 **caractérisé en ce que** L représente un ligand choisi parmi le 1,5-cyclooctadiène et le bis(triméthylsilyl)acétylène.

7. Procédé pour le dépôt chimique en phase gazeuse d'un métal choisi parmi le cuivre et l'argent sur un support, ce procédé étant **caractérisé en ce que** l'on utilise un composé selon l'une quelconque des revendications 1 à 6 comme précurseur du cuivre ou de l'argent.

8. Procédé selon la revendication 7, **caractérisé en ce que** le support est constitué par un matériau choisi parmi Si, AsGa, InP, SiC, SiGe.

9. Procédé selon l'une quelconque des revendications 7 à 8, **caractérisé en ce que** le support comporte une ou plusieurs couches intermédiaires constituées d'au moins un matériau choisi parmi TiN, TiSiN, Ta, TaN, TaSiN, WN, WSiN.

10. Procédé selon l'une quelconque des revendications 7 à 9, **caractérisé en ce qu'**il est mis en oeuvre à une température allant de 120 à 300°C.

11. Procédé selon l'une quelconque des revendications 7 à 10, **caractérisé en ce que** le précurseur de cuivre ou d'argent est utilisé pur.

12. Procédé selon l'une quelconque des revendications 7 à 10, **caractérisé en ce que** le précurseur de cuivre ou d'argent est utilisé en solution dans un solvant.

13. Utilisation d'un procédé selon l'une quelconque des revendications 7 à 12 pour le dépôt d'une couche de cuivre ou d'argent d'une épaisseur allant de 0,2 à 500 nm.

14. Utilisation d'un procédé selon l'une quelconque des revendications 7 à 12 pour la fabrication d'un circuit intégré.

## Claims

1. Compounds, **characterized in that** they have formula (I) below: 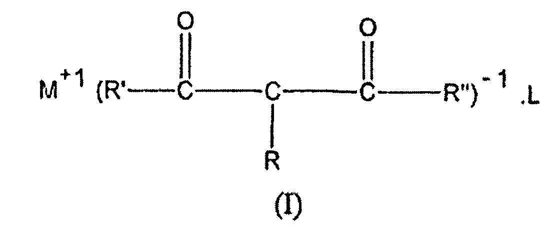 in which:
- M is a copper atom or a silver atom;
- R' and R", which are identical or different, are a group selected from a C₁-C₈ alkyl; and a group -OR''', where R''' is a C₁-C₈ alkyl;
- R is a group selected from a group -OR'''', where R"" is a C₁-C₈ alkyl; a nitro group: -NO₂; an aldehyde group: -CHO; and an ester group: -COOR''''', where R''''' is a C₁-C₈ alkyl group; and
- L is a stabilizing ligand.

2. Compound of formula (I), **characterized in that** L is selected from:
a- carbon monoxide;
b- unsaturated hydrocarbon ligands containing at least one non-aromatic unit of unsaturation;
c- isonitriles;
d- phosphines;
e- compounds of formula (II) below:
(R¹)(R²)C=C(R³)Si(R⁴)(R⁵)(R⁶)
in which:
- R¹ is a hydrogen atom, a C₁-C₈ alkyl group or a group Si(R⁴)(R⁵)(R⁶);
- R² and R³, which are identical or different, are a hydrogen atom or a C₁-C₈ alkyl group; and
- R⁴, R⁵ and R⁶, which are identical or different, are a phenyl or C₁-C₈ alkyl group;
f- compounds of formula (III) below:
R⁷-C≡C-Si(R⁸)(R⁹)(R¹⁰) (III)
in which:
- R⁷ is a C₁-C₈ alkyl or phenyl group or a group Si(R⁸)(R⁹)(R¹⁰); and
- R⁸, R⁹ and R¹⁰, which are identical or different, are a C₁-C₈ alkyl or phenyl group; and
g- compounds of one of formulae (IV), (V) and (VI) below: 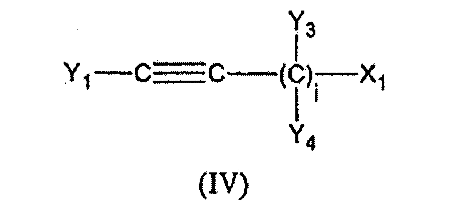 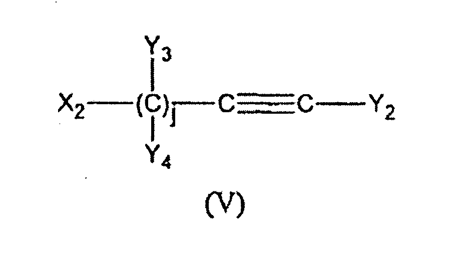 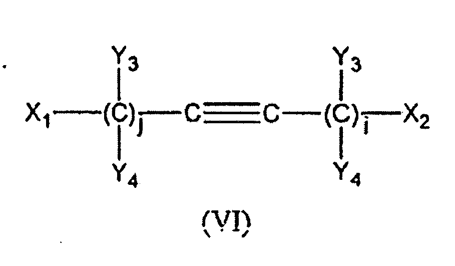
in which Y₁, Y₂, Y₃ and Y₄, which are identical or different, are selected from a hydrogen atom, a C₁-C₈ alkyl and a group -Si(R₅)₃, where R₅ is a C₁-C₈ alkyl, i and j are an integer selected from 0, 1, 2 and 3, and X₁ and X₂, which are identical or different, are an electron attracting group such as, in particular, a C₁-C₈ alkenyl.

3. Compound according to Claim 1 or Claim 2, **characterized in that** M is a copper atom.

4. Compound according to any one of Claims 1 to 3, **characterized in that** R' or R" is a group selected from CH₃ and C₂H₅.

5. Compound according to any one of Claims 1 to 4, **characterized in that** R is a group selected from NO₂ and OCH₃.

6. Compound according to any one of Claims 1 to 5, **characterized in that** L is a ligand selected from 1,5-cyclooctadiene and bis(trimethylsilyl)acetylene.

7. Process for the chemical vapour deposition of a metal selected from copper and silver onto a substrate, said process being **characterized in that** a compound according to any one of Claims 1 to 6 is used as a copper or silver precursor.

8. Process according to Claim 7, **characterized in that** the substrate consists of a material selected from Si, AsGa, InP, SiC and SiGe.

9. Process according to Claim 7 or 8, **characterized in that** the substrate has one or more intermediate layers consisting of at least one material selected from TiN, TiSiN, Ta, TaN, TaSiN, WN and WSiN.

10. Process according to any one of Claims 7 to 9, **characterized in that** it is carried out at a temperature ranging from 120 to 300°C.

11. Process according to any one of Claims 7 to 10, **characterized in that** the copper or silver precursor is used pure.

12. Process according to any one of Claims 7 to 10, **characterized in that** the copper or silver precursor is used in solution in a solvent.

13. Use of a process according to any one of Claims 7 to 12 for the deposition of a layer of copper or silver with a thickness ranging from 0.2 to 500 nm.

14. Use of a process according to any one of Claims 7 to 12 for the manufacture of an integrated circuit.

## Patentansprüche

1. Verbindungen, **dadurch gekennzeichnet, dass** sie der folgenden Formel (I) entsprechen: 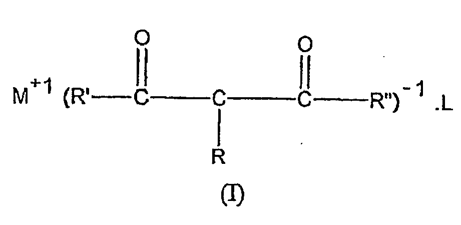 in der
- M ein Kupferatom oder ein Silberatom darstellt;
- R' und R", die identisch oder unterschiedlich sind, eine Gruppe darstellen, die aus einem C₁-C₈-Alkyl, einer Gruppe
- OR"', worin R"' ein C₁-C₈-Alkyl darstellt, ausgewählt sind;
- R eine Gruppe darstellt, die aus einer Gruppe -OR"", worin R"" ein C₁-C₈-Alkyl darstellt; einer Nitrogruppe: NO₂; einer Aldehydfunktion: -CHO; einer Esterfunktion: -COOR""', worin R""' eine C₁-C₈-Alkylgruppe darstellt; ausgewählt ist;
- L einen Stabilisierungsliganden darstellt.

2. Verbindung der Formel (I), **dadurch gekennzeichnet, dass** L ausgewählt ist aus:
a- Kohlenmonoxid,
b- ungesättigten Kohlenwasserstoffliganden, die wenigstens eine nicht-aromatische Ungesättigtheit enthalten,
c- Isonitrilen,
d- Phosphinen,
e- Verbindungen, die der folgenden Formel (II) entsprechen:
(R¹)(R²)C=C(R³)Si(R⁴)(R⁵)(R⁶)
worin
- R¹ ein Wasserstoffatom oder eine C₁-C₈-Alkylgruppe oder eine SiR⁴R⁵R⁶-Gruppe darstellt;
- R² und R³, die identisch oder unterschiedlich sind, ein Wasserstoffatom oder eine C₁-C₈-Alkylgruppe darstellen;
- R⁴, R⁵ und R⁶, die identisch oder unterschiedlich sind, eine Phenylgruppe oder eine C₁-C₈-Alkylgruppe darstellen;
f- Verbindungen, die der folgenden Formel (III) entsprechen:
R⁷―C≡C―Si(R⁸)(R⁹)(R¹⁰) (III)
in der
- R⁷ eine C₁-C₈-Alkylgruppe, Phenyl oder Si(R⁸)(R⁹)(R¹⁰) darstellt;
- R⁸, R⁹, R¹⁰, die identisch oder unterschiedlich sind, eine C₁-C₈-Alkylgruppe oder eine Phenylgruppe darstellen;
g- Verbindungen, die einer der folgenden Formeln (IV), (V) und (VI) entsprechen: 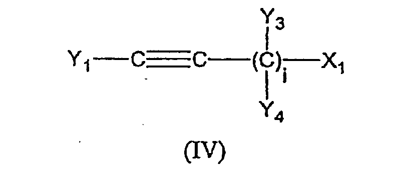 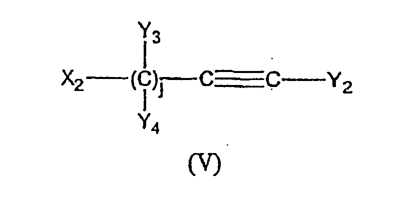 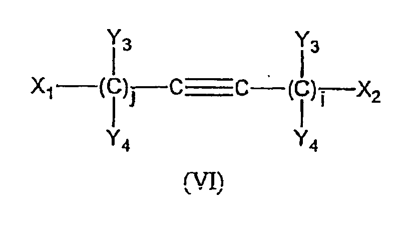
in denen Y₁, Y₂, Y₃ und Y₄, die identisch oder unterschiedlich sind, unter einem Wasserstoffatom, einem C₁-C₈-Alkyl, einer -Si(R₅)₃, worin R₅ ein C₁-C₈-Alkyl ist, ausgewählt sind, i und j eine ganze Zahl, ausgewählt aus 0, 1, 2, 3, darstellen und X₁ und X₂, die identisch oder unterschiedlich sind, eine elektronenanziehende Gruppe wie insbesondere ein C₁-C₈₋Alkenyl, darstellen.

3. Verbindung nach Anspruch 1 oder Anspruch 2, **dadurch gekennzeichnet, dass** M ein Kupferatom darstellt.

4. Verbindung nach einem der Ansprüche 1 bis 3, **dadurch gekennzeichnet, dass** R' oder R" eine Gruppe, ausgewählt aus CH₃ und C₂H₅, darstellt.

5. Verbindung nach einem der Ansprüche 1 bis 4, **dadurch gekennzeichnet, dass** R eine Gruppe, ausgewählt aus NO₂ und OCH₃, darstellt.

6. Verbindung nach einem der Ansprüche 1 bis 5, **dadurch gekennzeichnet, dass** L einen Liganden darstellt, der aus 1,5-Cyclooctadien und Bis(trimethylsilyl)acetylen ausgewählt ist.

7. Verfahren zum chemischen Abscheiden eines Metalls, ausgewählt aus Kupfer und Silber, in Gasphase auf einem Träger, wobei das Verfahren **dadurch gekennzeichnet ist, dass** man eine Verbindung nach einem der Ansprüche 1 bis 6 als Vorläufer des Kupfers oder des Silbers verwendet.

8. Verfahren nach Anspruch 7, **dadurch gekennzeichnet, dass** der Träger aus einem Material besteht, das aus Si, AsGa, InP, SiC, SiGe ausgewählt ist.

9. Verfahren nach einem der Ansprüche 7 bis 8, **dadurch gekennzeichnet, dass** der Träger eine oder mehrere Zwischenschichten enthält, die aus wenigstens einem Material bestehen, das unter TiN, TiSiN, Ta, TaN, TaSiN, WN, WSiN ausgewählt ist.

10. Verfahren nach einem der Ansprüche 7 bis 9, **dadurch gekennzeichnet, dass** es bei einer Temperatur von 120 bis 300°C durchgeführt wird.

11. Verfahren nach einem der Ansprüche 7 bis 10, **dadurch gekennzeichnet, dass** der Vorläufer von Kupfer oder Silber rein verwendet wird.

12. Verfahren nach einem der Ansprüche 7 bis 10, **dadurch gekennzeichnet, dass** der Vorläufer von Kupfer oder Silber in Lösung in einem Lösungsmittel verwendet wird.

13. Verwendung eines Verfahrens nach einem der Ansprüche 7 bis 12 zur Abscheidung einer Schicht aus Kupfer oder Silber mit einer Dicke von 0,2 bis 500 nm.

14. Verwendung eines Verfahrens nach einem der Ansprüche 7 bis 12 zur Herstellung eines integrierten Schaltkreises.
